# EUROPEAN PATENT SPECIFICATION

(11) **EP 3 611 758 B1**
(45) Date of publication and mention of the grant of the patent: **27.10.2021**
(21) Application number: 18784515.1
(22) Date of filing: 19.03.2018
(51) Int. Cl.: H01L 21/304, C09D 127/00, H01L 21/683, B24B 37/30, C08L 83/04, C08G 77/14, C08G 77/16

(54) **WAFER-RETAINING ELASTIC FILM OF CMP DEVICE**
WAFERHALTENDE ELASTISCHE FOLIE EINER CMP-VORRICHTUNG
FILM ÉLASTIQUE DE RETENUE DE PLAQUETTE DE DISPOSITIF DE POLISSAGE CHIMICO-MÉCANIQUE

(30) Priority: 13.04.2017 JP 2017079588
(43) Date of publication of application: 19.02.2020
(73) Proprietor: Mitsubishi Cable Industries, Ltd., Chiyoda-ku Tokyo 100-8303 (JP); Akros Co., Ltd., Aichi 485-0077 (JP)
(72) Inventor: YASUDA Hiroaki, Amagasaki-shi Hyogo 660-0856 (JP); HAMAMURA Takehiro, Amagasaki-shi Hyogo 660-0856 (JP); MAKINO Shin, Komaki-shi Aichi 485-0077 (JP); KUBOKURA Yuzuru, Komaki-shi Aichi 485-0077 (JP)
(74) Representative: BRP Renaud & Partner mbB Rechtsanwälte Patentanwälte Steuerberater
(86) International application number: PCT/JP2018/010815
(87) International publication number: WO 2018/190079

(56) References cited:
- JP-A- H0 661 202
- JP-A- 2005 072 496
- JP-A- 2005 344 052
- JP-A- 2010 182 918
- JP-U- 3 179 929
- US-A1- 2009 242 125

## Description

### TECHNICAL FIELD

The present invention relates to wafer-retaining elastic films of CMP devices.

### BACKGROUND ART

With increased miniaturization of semiconductor chips, semiconductor chips have an increasingly smaller horizontal dimension and an increasingly complicated structure in the vertical direction. Chemical mechanical polishing (CMP) devices for polishing and planarizing a wafer surface have been put into practical use in response to the need to planarize the surface of a wafer to be processed. The CMP devices retain a wafer with a wafer retaining member and polishes the surface of the wafer with a polishing pad in contact with the wafer. The wafer retaining member has a wafer-retaining elastic film that allows a wafer to contact the polishing pad with a uniform pressure. This elastic film has a coating layer on the wafer retaining surface of its film body in order to eliminate or reduce the risk of damage to a wafer due to the wafer closely adhering to the elastic film and not being able to be separated from the elastic film. For example, Patent Document 1 discloses a wafer-retaining elastic film having a parylene coating layer on its wafer retaining surface. Patent Document 2 discloses a wafer-retaining elastic film having a fluororesin coating layer on its wafer retaining surface. Patent Document 3 does not disclose a wafer-retaining elastic film but discloses a rubber product having a diamond-like carbon (DLC) coating layer on its surface. Patent Document 4 discloses a rubber seal having a silicone resin coating layer on its surface.

### CITATION LIST

### PATENT DOCUMENTS

PATENT DOCUMENT 1: United States Patent Application Publication No. 2005/0221734
PATENT DOCUMENT 2: Japanese Patent No. 4086722
PATENT DOCUMENT 3: Japanese Patent No. 3791060
PATENT DOCUMENT 4: Japanese Unexamined Patent Publication No. H02-64109
PATENT DOCUMENT 5: United States Patent Application Publication No. US 2009/242125 A1
PATENT DOCUMENT 6: Japanese Utility Model No. JP 3 179929 U
PATENT DOCUMENT 7: Japanese Unexamined Patent Publication No. JP 2005 344052 A

### SUMMARY OF THE INVENTION

### TECHNICAL PROBLEM

Properties required for coating layers of wafer-retaining elastic films of CMP devices include: high tribological properties and low adhesive properties for restraining undesirable separation of a wafer; high water repellency for antifouling; high wear resistance for durability; low hardness for maintaining contact of a wafer with the polishing pad with a uniform pressure; high adhesion to the film body for restraining undesirable separation of a wafer due to peeling off of the coating layer and for antifouling; and ease of forming the coating layer only on a necessary part of the film body.

However, the parylene coating layer disclosed in Patent Document 1 has high adhesive properties, low water repellency, high hardness, and low wear resistance. Moreover, since the parylene coating layer is formed by vapor deposition, production cost is high. The fluororesin coating layer disclosed in Patent Document 2 has low wear resistance and has low adhesion to a film body. The diamond-like carbon coating layer disclosed in Patent Document 3 has low tribological properties, low water repellency, high hardness, and low adhesion to a film body. Moreover, since the diamond-like carbon coating layer is formed by vapor deposition, production cost is high. The silicone resin coating layer disclosed in Patent Document 4 has low tribological properties and low wear resistance. The coating layers disclosed in Patent Documents 1 to 4 do not have all of the properties required for coating layers of wafer-retaining elastic films of CMP devices. Also, coatings described in Patent Documents 5, 6 and 7 do not have all of the properties required for coating layers.

It is an object of the present invention to provide a wafer-retaining elastic film of a CMP device which has all of the following properties: high tribological properties and low adhesive properties, high water repellency, high wear resistance, low hardness, high adhesion to a film body, and ease of forming a coating layer only on a necessary part of the film body.

### SOLUTION TO THE PROBLEM

The present invention is solved by a wafer-retaining elastic film of a CMP device as defined in claim 1. Preferred embodiments are defined in the dependent claims. A wafer-retaining elastic film of a CMP device according to the present invention includes: a film body comprised of an elastic material; and a coating layer formed so as to cover a surface on a wafer retaining side of the film body. The coating layer contains a polymeric binder and nonmetallic particles dispersed in the polymeric binder. The polymeric binder is comprised of silicone rubber and the nonmetallic particles are comprised of polytetrafluoroethylene.

### ADVANTAGES OF THE INVENTION

According to the present invention, the coating layer formed so as to cover the wafer-retaining surface of the film body contains the polymeric binder and the nonmetallic particles dispersed in the polymeric binder. The polymeric binder is comprised of silicone rubber and the nonmetallic particles are comprised of polytetrafluoroethylene. The coating layer thus has all of the following properties: high tribological properties and low adhesive properties, high water repellency, high wear resistance, low hardness, high adhesion to the film body, and ease of forming the coating layer only on a necessary part of the film body.

### BRIEF DESCRIPTION OF THE DRAWINGS

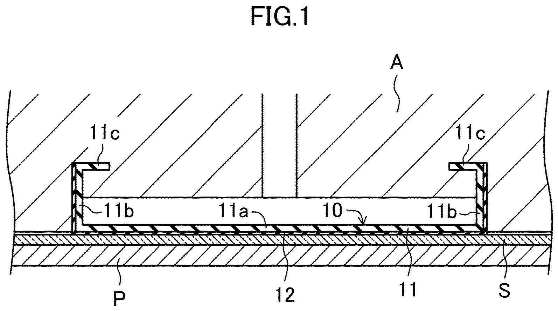

[FIG. 1] FIG. 1 is a sectional view of an elastic film according to an embodiment.

### DESCRIPTION OF EMBODIMENTS

An embodiment will be described in detail below.

FIG. 1 shows a wafer-retaining elastic film 10 of a CMP device A according to an embodiment. The elastic film 10 according to the embodiment is attached to the CMP device A with its surface on one side facing the CMP device A and its surface on the other side being exposed to the outside. The elastic film 10 retains a wafer S on the surface on the other side by suction so that the wafer S contacts a polishing pad P. In the following description, the one side of the elastic film 10 according to the embodiment is referred to as the "device attachment side" and the other side thereof is referred to as the "wafer retaining side."

The elastic film 10 according to the embodiment has a film body 11 that forms the outer shape of the elastic film 10. The film body 11 is in the shape of a shallow circular dish having a circular portion 11a, a cylindrical portion 11b having the shape of a vertical wall and formed integrally with the circular portion 11a on the device attachment side of the peripheral edge of the circular portion 11a, and an annular portion 11c formed integrally with the cylindrical portion 11b so as to extend continuously inward from the upper end of the cylindrical portion 11b. A plurality of annular pressure chambers are defined inside the film body 11.

The film body 11 is comprised of an elastic material. Examples of the elastic material forming the film body 11 include common crosslinked rubber materials such as silicone rubber, chloroprene rubber, EPDM, NBR, natural rubber, and fluororubber. It is suitable to use one or more of these rubber materials as the elastic material forming the film body 11. In order to allow the wafer S to contact the polishing pad P with a uniform pressure, it is more suitable to use flexible silicone rubber as the elastic material forming the film body 11. Examples of the silicone rubber include (meth)acryloyloxy group-containing polysiloxanes, vinyl polysiloxanes, and mercaptoalkyl group-containing polysiloxanes.

The elastic film 10 according to the embodiment has a coating layer 12 formed so as to cover the surface of the film body 11. Specifically, the coating layer 12 is formed so as to cover the surface on the wafer retaining side of the circular portion 11a of the film body 11, and this surface of the coating layer 12 serves as a wafer suction surface. For easy attachment to the CMP device A due to improved tribological properties, it is suitable that the coating layer 12 be formed so as to cover the outer peripheral surface of the cylindrical portion 11b continuously with the surface on the wafer retaining side of the circular portion 11a. In order to smoothly polish a wafer, it is necessary to precisely control the pressure in the pressure chambers inside of the film body 11. If the coating layer 12 is formed on the innner side of the film body 11, the pressure will escape from the pressure chambers and it is difficult to control the pressure in the pressure chambers. It is therefore suitable that the coating layer 12 not be formed on the device attachment side of the film body 11, namely on the surface on the device attachment side of the circular portion 11a, the inner peripheral surface of the cylindrical portion 11b, and either surface of the annular portion 11c.

The coating layer 12 contains a polymeric binder and nonmetallic particles dispersed in the polymeric binder.

The polymeric binder is suitably a photocurable or thermosetting coating film. The term "photocurable" herein includes UV-curable. Examples of the polymeric binder include silicone rubber, modified silicone rubber, silicone resin, modified silicone resin, epoxy resins, acrylic rubber, acrylic resins, urethane rubber, and urethane resins. According to the invention, the polymeric binder is comprised of silicone rubber.

It is suitable to use one or more of these materials as the polymeric binder. The film body 11 is suitably comprised of silicone rubber. Accordingly, in view of affinity with the film body 11, it is suitable to use silicone rubber or silicone resin as the polymeric binder. In view of coating flexibility, it is more suitable to use silicone rubber as the polymeric binder. Silicone rubber is roughly classified into liquid silicone rubber and solid silicone rubber. Either liquid silicone rubber or solid silicone rubber can be used as both liquid silicone rubber and solid silicone rubber can be dissolved in a solvent when used. However, since solid silicone rubber is prone to stringing when dissolved, it is more suitable to use liquid silicone rubber. Liquid silicone rubber is classified into polycondensation silicone rubber and polyaddition liquid silicone rubber depending on the crosslinking form. Polyaddition liquid silicone rubber is susceptible to catalyst poisoning, and the type of film body 11 and the type of nonmetallic particles are limited when polyaddition liquid silicone rubber is used. It is therefore more suitable to use polycondensation liquid silicone rubber. Polycondensation liquid silicone rubber is classified into, e.g., acetic acid type, alcohol type, oxime type, amine type, aminooxy type, acetone type, dehydrogenation type, dehydration type, etc. depending on the reaction mechanism. In view of corrosiveness to metals, it is particularly suitable to use alcohol type or acetone type.

The nonmetallic particles are comprised of a thermoplastic resin or a thermosetting resin. Examples of the resin forming the nonmetallic particles include fluororesins, polyolefin resins, polyamide resins, polyacetal resins, and phenolic resins. According to the invention, the nonmetallic particles are comprised of polytetrafluoroethylene.

Examples of the fluororesins include polytetrafluoroethylene (hereinafter referred to as "PTFE"), polyvinyl fluoride (PVF), polyvinylidene fluoride (PVDF), polychlorotrifluoroethylene (CTFE), tetrafluoroethylene-hexafluoro copolymers (FEP), tetrafluoroethylene-perfluoroalkyl vinyl ether copolymers (PFA), ethylene-tetrafluoroethylene copolymers (ETFE), and ethylene-polychlorotrifluoroethylene copolymers (ECTFE).

Examples of the polyolefin resins include polyethylene (PE), polypropylene (PP), and ethylene-propylene copolymers (EPR). Examples of the polyamide resins include aliphatic polyamides such as nylon 66 (PA 66) and nylon 46 (PA 46) and semi-aromatic polyamides such as nylon 6T (PA 6T) and nylon 9T (PA 9T). Examples of the polyacetal resins include homopolymers and copolymers having an oxymethylene structure as a unit structure. Examples of the phenolic resins include novolac phenolic resins and resole phenolic resins.

It is suitable to use one or more of these materials as the nonmetallic particles. For non-adhesive properties, high tribological properties, and high water repellency, it is suitable to use a fluororesin and it is more suitable to use PTFE.

For high tribological properties, the average particle size of the nonmetallic particles is suitably 0.01 µm or more and 20 µm or less, and more suitably 0.1 µm or more and 10 µm or less. The average particle size of the nonmetallic particles is measured by laser diffraction scattering.

For high tribological properties and high water repellency, the content of the nonmetallic particles in the coating layer 12 is suitably 25 parts by mass or more and 500 parts by mass or less, and more suitably 60 parts by mass or more and 120 parts by mass, per 100 parts by mass of the polymeric binder.

The coating layer 12 may contain an antistatic agent. Examples of the antistatic agent include ionic liquids. Examples of the ionic liquids include pyridinium-based ionic liquids, aliphatic amine-based ionic liquids, alicyclic amine-based ionic liquids, imidazolium-based ionic liquids, and aliphatic phosphonium-based ionic liquids. It is suitable to use one or more of these ionic liquids as the antistatic agent. The content of the antistatic agent in the coating layer 12 is suitably 0.2 parts by mass or more and 20 parts by mass or less, and more suitably 1 part by mass or more and 10 parts by mass or less, per 100 parts by mass of the polymeric binder.

The coating layer 12 may further contain a catalyst, a lubricant, a mold release agent, etc.

For high tribological properties and high water repellency and in view of the balance between the capability to restrain peeling of the coating layer 12 and the cost, the thickness of the coating layer 12 is suitably 1 µm or more and 20 µm or less, and more suitably 2 µm or more and 10 µm or less.

For non-adhesive properties, high tribological properties, and high water repellency, the arithmetic average roughness (Ra) of the surface of the coating layer 12 is suitably 0.1 µm or more and 5 µm or less, and more suitably 0.3 µm or more and 3 µm or less.

A method for producing the elastic film 10 according to the embodiment will be described.

First, the film body 11 is formed by press forming etc. A coating solution is prepared by mixing a polymeric binder base material, nonmetallic particles, a catalyst, and a solvent (xylene, toluene, hexane, etc.).

Next, a part of the film body 11 on which the coating layer 12 is to be formed (the surface on the wafer retaining side of the circular portion 11a of the film body 11 and the outer peripheral surface of the cylindrical portion 11b which is continuous with the surface on the wafer retaining side of the circular portion 11a) is coated with the coating solution. This coating is performed by, e.g., spray coating, spin coating, dip coating, etc. Of these coating methods, spray coating is suitable in view of cost and ease of forming the coating layer 12 only on a necessary part of the film body 11 and to adjust the thickness of the coating layer 12.

The film body 11 thus coated with the coating solution is heated in an oven or on a hot plate to form the coating layer 12. The elastic film 10 according to the embodiment is produced in this manner. The heating temperature is, e.g., 80°C or higher and 120°C or less, and the heating time is 20 minutes or more and 40 minutes or less.

According to the elastic film 10 of the embodiment having the above configuration, the coating layer 12 formed so as to cover the surface on the wafer retaining side of the film body 11 contains the polymeric binder and the nonmetallic particles dispersed in the polymeric binder. Due to the nonmetallic particles, the elastic film 10 has high tribological properties and low adhesive properties for restraining undesirable separation of a wafer, high water repellency for antifouling, and high wear resistance for durability. Due to flexibility of the polymeric binder, the elastic film 10 further has low hardness for maintaining contact of the wafer S with the polishing pad P with a uniform pressure and high adhesion to the film body 11 for restraining undesirable separation of the wafer S due to peeling off of the coating layer 12 and for antifouling. Moreover, since the coating layer 12 can be formed by a common coating method such as spray coating, spin coating, or dip coating, the coating layer 12 is formed at low cost and it is easy to form the coating layer 12 only on a necessary part of the film body 11 and to adjust the thickness of the coating layer 12. The coating layer 12 of the elastic film 10 according to the embodiment thus has all of the following properties required for coating layers: high tribological properties and low adhesive properties, high water repellency, high wear resistance, low hardness, high adhesion to the film body 11, and ease of forming the coating layer 12 only on a necessary part of the film body 11.

### Examples

### (Coating Layer Test Pieces)

Test pieces of the following Examples 1 to 3 and Comparative Examples 1 to 5 were produced for each test described below.

### <Example 1>

A silicone rubber base material was produced by press forming. A coating solution having a solid concentration of 10 mass% was prepared by mixing 82.5 parts by mass of PTFE powder (LUBRON L-2, made by DAIKIN INDUSTRIES, LTD., average particle size: 3.5 µm) that is nonmetallic particles and 0.9 parts by mass of CAT-RM that is a catalyst per 100 parts by mass of liquid condensation curing silicone rubber (KE-12, made by Shin-Etsu Chemical Co., Ltd.) that is a polymeric binder base material and adding the mixture to an organic solvent.

The surface of the base material was coated with the coating solution by spray coating, and the resultant base material was heated in an oven at 80°C for 30 minutes to form a coating layer with a thickness of 2.5 µm. The test piece thus produced was used as Example 1.

### <Example 2>

A test piece was produced by a method similar to that of Example 1 except that the surface of the base material was coated more times with the coating solution than in Example 1 to form a coating layer with a thickness of 10 µm. This test piece was used as Example 2.

### <Example 3>

A test piece was produced by a method similar to that of Example 2 except that 3.8 parts by mass of an antistatic agent (CIL-312, made by Japan Carlit Co., Ltd.) was added per 100 parts by mass of liquid condensation curing silicone rubber. This test piece was used as Example 3.

### <Comparative Example 1>

A test piece was produced without coating a base material with a coating solution. This test piece was used as Comparative Example 1.

### <Comparative Example 2>

A test piece was produced by forming a parylene coating layer with a thickness of 0.5 µm on a base material by vapor deposition. This test piece was used as Comparative Example 2.

### <Comparative Example 3>

A test piece was produced by forming a diamond-like carbon coating layer with a thickness of 0.5 µm on a base material by vapor deposition. This test piece was used as Comparative Example 3.

### <Comparative Example 4>

A test piece was produced by forming a coating layer with a thickness of 10 µm on a base material by using a fluorine coating agent (MK-2, made by AGC SEIMI CHEMICAL CO., LTD.). This test piece was used as Comparative Example 4.

### <Comparative Example 5>

A test piece was produced by forming a coating layer with a thickness of 10 µm on a base material by using a silicone coating agent (HS-4, made by TANAC Co., Ltd.). This test piece was used as Comparative Example 5.

### <Comparative Example 6>

A test piece was produced by forming a coating layer with a thickness of 10 µm on a base material by using a silicone coating agent (SAT-1000P, made by Shinko Technical Research Co., Ltd.). This test piece was used as Comparative Example 6.

### (Test Evaluation Method)

### <Tribological Properties>

Sheet-like test pieces of Examples 1 to 3 and Comparative Examples 1 to 6, each having a length of 100 mm, a width of 50 mm, and a thickness of 2 mm, were prepared, and the coefficient of static friction of the coating layer of each test piece was obtained with a surface property tester (HEIDON TYPE: 14, made by Shinto Scientific Co., Ltd.). Specifically, the surface of the coating layer of each test piece was washed with methanol, and the test piece was then dried in an atmosphere having a temperature of 20°C and humidity of 40%. The test piece thus dried was placed on the stage of the surface property tester. With a 10-mm diameter spherical tip of a SUS304 gauge head being in contact with the coating layer, the gauge head was caused to slide on the coating layer at 75 mm/min under a load of 0.98 N. The coefficient of static friction was calculated from the frictional force measured at this time. The lower the coefficient of static friction is, the higher the tribological properties are.

### <Adhesive Properties>

V-15 size O ring-shaped test pieces of Examples 1 to 3 and Comparative Examples 1 to 6, each having an inside diameter of 14.5 mm and a wire diameter of 4.0 mm, were prepared, and the adhesive force of each test piece to a test jig was obtained as adhesive properties of the test piece. Specifically, each test piece was held between two SUS304 plate-like test jigs, compressed by 25%, and fixed. In this state, the test piece was heated at 175°C for 24 hours and then cooled at room temperature for 8 hours. Subsequently, the two test jigs were pulled apart at 1 mm/min, and the pulling force was measured with a load cell. The maximum measured value of the pulling force was obtained as the adhesive force. The lower the adhesive force is, the lower the adhesive properties are.

### <Water Repellency>

Sheet-like test pieces of Examples 1 to 3 and Comparative Examples 1 to 6, each having a length of 100 mm, a width of 50 mm, and a thickness of 2 mm, were prepared, and the contact angle between the coating layer of each test piece and pure water was measured with a contact angle meter (DMo-501, made by Kyowa Interface Science Co., Ltd.). The surface of the coating layer of each test piece was washed with methanol and then the test piece was dried in an atmosphere having a temperature of 20°C and humidity of 40%. The test pieced thus dried was used for measurement of the contact angle. The larger the contact angle is, the higher the water repellency is.

### <Wear Resistance>

Sheet-like test pieces of Examples 1 to 3 and Comparative Examples 1 to 6 were subjected to a thrust wear test. Specifically, with the end face of an S45C ring-shaped test jig, which has arithmetic average roughness (Ra) of 1.0 ± 0.5 µm, being in contact with the surface of the coating layer of each test piece, the test jig was rotated at 0.5 m/sec (417 rpm) at room temperature. At this time, the test piece was compressed by the test jig under a load of 10 N for 5 minutes, and then the load was increased to 60 N in increments of 10 N every 5 minutes. Wear loss before and after the test was measured. The smaller the wear loss is, the higher the wear resistance is.

### <Hardness>

For sheet-like test pieces of Examples 1 to 3 and Comparative Examples 1 to 6, hardness of the coating layer, which is equivalent to Shore A hardness, was measured with a micro rubber durometer (MD-1 capa, made by Kobunshi Keiki Co., Ltd.).

### <Adhesion>

Each of sheet-like test pieces of Examples 1 to 3 and Comparative Examples 1 to 6 was stretched by 80%, and the surface of the coating layer was observed at 100x magnification with a microscope to check for cracks. When no crack is observed in the coating layer, it means that the coating layer closely adheres to the base material.

The sheet-like test pieces of Examples 1 to 3 and Comparative Examples 1 to 6 were also subjected to a cross cut adhesion test in accordance with JIS K 5600-5-6 to check for peeling of the coating layer from the base material. When no peeling of the coating layer is observed, it means that the coating layer closely adheres to the base material.

### <Antistatic Properties>

For sheet-like test pieces of Examples 1 to 3 and Comparative Example 1 to 6, an initial value of the withstand voltage was measured in accordance with the method A (half-life measurement) defined in JIS L 1094: 2014. The lower the withstand voltage is, the higher the antistatic properties are.

### (Test Evaluation Results)

Table 1 shows the test results.

**[Table 1]**

| | | Examples | | | Comparative Examples | | | | | |
|---|---|---|---|---|---|---|---|---|---|---|
| Coating Layer | | 1 | 2 | 3 | 1 | 2 | 3 | 4 | 5 | 6 |
| | | Silicone + Sliding Material | Silicone + Sliding Material | Silicone + Sliding Material | No Coating | Parylene Coating | DLC Coating | Fluorine Coating Agent | Silicone Coating Agent | Fluorine-Modified Silicone Coating Agent |
| Coating Method | | Spray Coating | Spray Coating | Spray Coating | - | Vapor Deposition | Vapor Deposition | Spray Coating | Spray Coating | Spray Coating |
| Thickness, µm | | 2.5 | 10 | 10 | - | 0.5 | 0.5 | 10 | 10 | 10 |
| Adhesive Properties | Adhesive Force, N | 0 | 0 | 0 | 24 | 110 | 18 | 18 | 30 | 20 |
| Tribological Properties | Coefficient of Static Friction | 0.29 | 0.21 | 0.21 | 0.52 | 0.30 | 0.35 | 0.22 | 0.37 | 0.25 |
| Water Repellency | Contact Angle, ° | 118 | 118 | 114 | 108 | 102 | 109 | 120 | 112 | 110 |
| Wear Resistance | Wear Loss, mg | 1.2 | 1.8 | 1.8 | 74.2 | 3.3 | 1.5 | 8.0 | 10 | 8.0 |
| Hardness | Shore A | 46 | 46 | 46 | 40 | 50 | 50 | 47 | 45 | 45 |
| Adhesion | 80% stretched, cracks | No | No | No | - | No | Yes | Yes | No | No |
| | Cross Cut, Peeling | No | No | No | - | No | No | Yes | No | No |
| Antistatic Properties | Withstand Voltage, V | 1200 | 1200 | 0 | 1200 | 1200 | 1200 | 2000 | 1200 | 1500 |

The results in Table 1 show that Examples 1 to 3 whose coating layer is comprised of a polymeric binder with nonmetallic particles dispersed therein have all of the following properties: high tribological properties and low adhesive properties, high water repellency, high wear resistance, low hardness, and high adhesion to the film body.

On the other hand, Comparative Example 1 having no coating layer has low tribological properties, low water repellency, low hardness, and significantly low wear resistance. Comparative Example 2 having a parylene coating layer has high adhesive properties, low water repellency, high hardness, and low wear resistance. Comparative Example 3 having a diamond-like carbon coating layer has low tribological properties, low water repellency, high hardness, and low adhesion to the film body. Comparative Example 4 having a coating layer of a fluorine coating agent has low wear resistance and low adhesion to the film body. Comparative Example 5 having a coating layer of a silicone coating agent has low tribological properties and low wear resistance. Comparative Example 6 having a coating layer of a fluorine-modified silicone coating agent has low water repellency and low wear resistance.

It was confirmed that Example 3 having a coating layer containing an antistatic agent has higher antistatic properties than the others.

### INDUSTRIAL APPLICABILITY

The present invention is useful in the technical field of wafer-retaining elastic films of CMP devices.

### DESCRIPTION OF REFERENCE CHARACTERS

- A: CMP Device
- S: Wafer
- P: Polishing Pad
- 10: Elastic Film
- 11: Film Body
- 11a: Circular Portion
- 11b: Cylindrical Portion
- 11c: Annular Portion
- 12: Coating Layer

## Claims

1. A wafer-retaining elastic film (10) of a CMP device (A), comprising:
a film body (11) comprised of an elastic material; and a coating layer (12) formed so as to cover a surface on a wafer retaining side of the film body (11),
**characterized in that**
the coating layer (12) contains a polymeric binder and nonmetallic particles dispersed in the polymeric binder, and
the polymeric binder is comprised of silicone rubber and the nonmetallic particles are comprised of polytetrafluoroethylene.

2. The elastic film (10) of claim 1, wherein
the nonmetallic particles have an average particle size of 0.01 µm or more and 20 µm or less.

3. The elastic film (10) of any one of claims 1 to 2, wherein
the coating layer (12) contains 25 parts by mass or more and 500 parts by mass or less of the nonmetallic particles per 100 parts by mass of the polymeric binder.

4. The elastic film (10) of any one of claims 1 to 3, wherein
the coating layer (12) contains an antistatic agent.

5. The elastic film (10) of claim 4, wherein
the coating layer (12) contains 0.2 parts by mass or more and 20 parts by mass or less of the antistatic agent per 100 parts by mass of the polymeric binder.

6. The elastic film (10) of any one of claims 1 to 5, wherein
the film body (11) has a circular portion (11a) having its surface on the wafer retaining side coated with the coating layer (12), and a cylindrical portion (11b) having the shape of a vertical wall and formed integrally with the circular portion (11a) on a device attachment side of a peripheral edge of the circular portion (11a), and
the coating layer (12) is formed so as to also cover an outer peripheral surface of the cylindrical portion (11b) which is continuous with the surface on the wafer retaining side of the circular portion (11a).

7. The elastic film (10) of claim 6, wherein
the coating layer (12) is not formed on a surface on the device attachment side of the circular portion (11a) and an inner peripheral surface of the cylindrical portion (11b).

8. The elastic film (10) of any one of claims 1 to 7, wherein
the film body (11) is comprised of silicone rubber.

## Patentansprüche

1. Elastische Waferhaltefolie (10) einer CMP-Vorrichtung (A), umfassend:
einen Folienkörper (11), der aus einem elastischen Material besteht; und eine Deckschicht (12), die so ausgebildet ist, dass sie eine Oberfläche auf einer Waferhalteseite des Folienkörpers (11) bedeckt,
**dadurch gekennzeichnet, dass**
die Deckschicht (12) ein polymeres Bindemittel und in dem polymeren Bindemittel dispergierte nichtmetallische Teilchen enthält, und
das polymere Bindemittel aus Silikonkautschuk besteht und die nichtmetallischen Teilchen aus Polytetrafluorethylen bestehen.

2. Elastische Folie (10) nach Anspruch 1, wobei
die nichtmetallischen Teilchen eine durchschnittliche Teilchengröße von 0,01 µm oder mehr und 20 µm oder weniger aufweisen.

3. Elastische Folie (10) nach einem der Ansprüche 1 bis 2, wobei
die Deckschicht (12) 25 Masseteile oder mehr und 500 Masseteile oder weniger der nichtmetallischen Teilchen pro 100 Masseteile des polymeren Bindemittels enthält.

4. Elastische Folie (10) nach einem der Ansprüche 1 bis 3, wobei
die Deckschicht (12) ein antistatisches Mittel enthält.

5. Elastische Folie (10) nach Anspruch 4, wobei
die Deckschicht (12) 0,2 Masseteile oder mehr und 20 Masseteile oder weniger des antistatischen Mittels pro 100 Masseteile des polymeren Bindemittels enthält.

6. Elastische Folie (10) nach einem der Ansprüche 1 bis 5, wobei
der Folienkörper (11) einen kreisförmigen Abschnitt (11a), dessen Oberfläche auf der Waferhalteseite mit der Deckschicht (12) beschichtet ist, und einen zylindrischen Abschnitt (11b), der die Form einer vertikalen Wand aufweist und einstückig mit dem kreisförmigen Abschnitt (11a) auf einer Vorrichtungsbefestigungsseite einer Umfangskante des kreisförmigen Abschnitts (11a) ausgebildet ist, aufweist, und
die Deckschicht (12) so ausgebildet ist, dass sie auch eine Außenumfangsfläche des zylindrischen Abschnitts (11b) bedeckt, die mit der Oberfläche auf der Waferhalteseite des kreisförmigen Abschnitts (11a) durchgehend ist.

7. Elastische Folie (10) nach Anspruch 6, wobei
die Deckschicht (12) nicht auf einer Oberfläche auf der Vorrichtungsbefestigungsseite des kreisförmigen Abschnitts (11a) und einer Innenumfangsfläche des zylindrischen Abschnitts (11b) ausgebildet ist.

8. Elastische Folie (10) nach einem der Ansprüche 1 bis 7, wobei
der Folienkörper (11) aus Silikonkautschuk besteht.

## Revendications

1. Film élastique de retenue de plaquette (10) d'un dispositif de polissage chimico-mécanique comprenant :
un corps de film (11) comprenant un matériau élastique; et une couche de revêtement (12) formée de façon à recouvrir une surface sur un côté de retenue de plaquette du corps de film (11).
**caractérisé en ce que**
la couche de revêtement (12) contient un liant polymère et des particules non métalliques dispersées dans le liant polymère, et
le liant polymère comprend du caoutchouc de silicone et les particules non métalliques comprennent du polytétrafluoroéthylène.

2. Film élastique (10) selon la revendication 1, dans lequel
les particules non métalliques présentent une taille de particule moyenne de 0,01 µm ou plus et de 20 µm ou moins.

3. Film élastique (10) selon l'une quelconque des revendications 1 à 2, dans lequel
la couche de revêtement (12) contient 25 parties en masse ou plus et 500 parties en masse ou moins de particules non métalliques par 100 parties en masse du lien polymère.

4. Film élastique (10) selon l'une quelconque des revendications 1 à 3, dans lequel
la couche de revêtement (12) contient un agent anti-statique.

5. Film élastique (10) selon la revendication 4, dans lequel
la couche de revêtement (12) contient 0,2 partie en masse ou plus et 20 parties en masse ou moins de l'agent anti-statique par 100 parties en masse du lien polymère.

6. Film élastique (10) selon l'une quelconque des revendications 1 à 5, dans lequel
le corps de film (11) présente une partie circulaire (11a) présentant sa surface sur le côté de retenue de plaquette revêtu de la couche de revêtement (12), et une partie cylindrique (11b) présentant la forme d'une paroi verticale et formée intégralement avec la partie circulaire (11a) sur un côté de fixation du dispositif d'un bord périphérique de la partie circulaire (11a), et
la couche de revêtement (12) est formée de manière à recouvrir également une surface périphérique extérieure de la partie cylindrique (11b) qui est continue avec la surface sur le côté de retenue de plaquette de la partie circulaire (11a).

7. Film élastique (10) selon la revendication 6, dans lequel
la couche de revêtement (12) n'est pas formée sur une surface sur le côté de fixation du dispositif de la partie circulaire (11a) et une surface périphérique intérieure de la partie cylindrique (11b).

8. Film élastique (10) selon l'une quelconque des revendications 1 à 7, dans lequel
le corps du film (11) comprend du caoutchouc de silicone.
